# EUROPEAN PATENT SPECIFICATION

(11) **EP 0 344 998 B1**
(45) Date of publication and mention of the grant of the patent: **07.12.1994**
(21) Application number: 89305396.7
(22) Date of filing: 26.05.1989
(51) Int. Cl.: H03H 17/02, G06J 1/00, H03M 1/66

(54) **Digital-to-analogue conversion**
Digital-Analogwandlung
Conversion numérique-analogique

(30) Priority: 03.06.1988 GB 8813162
(43) Date of publication of application: 06.12.1989
(60) Divisional application: 94102774.0
(73) Proprietor: BRITISH TELECOMMUNICATIONS public limited company, London EC1A 7AJ (GB)
(72) Inventor: Da Franca, Jose de Albuquerque Epifanio, P-1900 Lisboa (PT); Vital, Joao Paulo Calado Cordeiro, P-1200 Lisboa (PT); Leme, Carlos Mexia de Almeida de Azeredo, P-1000 Lisboa (PT)
(74) Representative: Lloyd, Barry George William

(56) References cited:
- GB-A- 2 171 568
- US-A- 4 616 212
- US-A- 4 620 158
- ELEKTOR, vol. 9, no. 1, January 1983, pages 1.36-1.42, Canterbury, Kent, GB;"Chips for digital audio"
- IEEE JOURNAL OF SOLID-STATE CIRCUITS, vol. SC-18, no. 6, December 1983, pages745-753, IEEE, New York, US; A.M. CHIANG et al.: "A high-speed digitallyprogrammable CCD transversal filter"

## Description

The present invention relates to digital-to-analogue converters incorporating a filtering function and particularly with their implementation using switched-capacitor techniques.

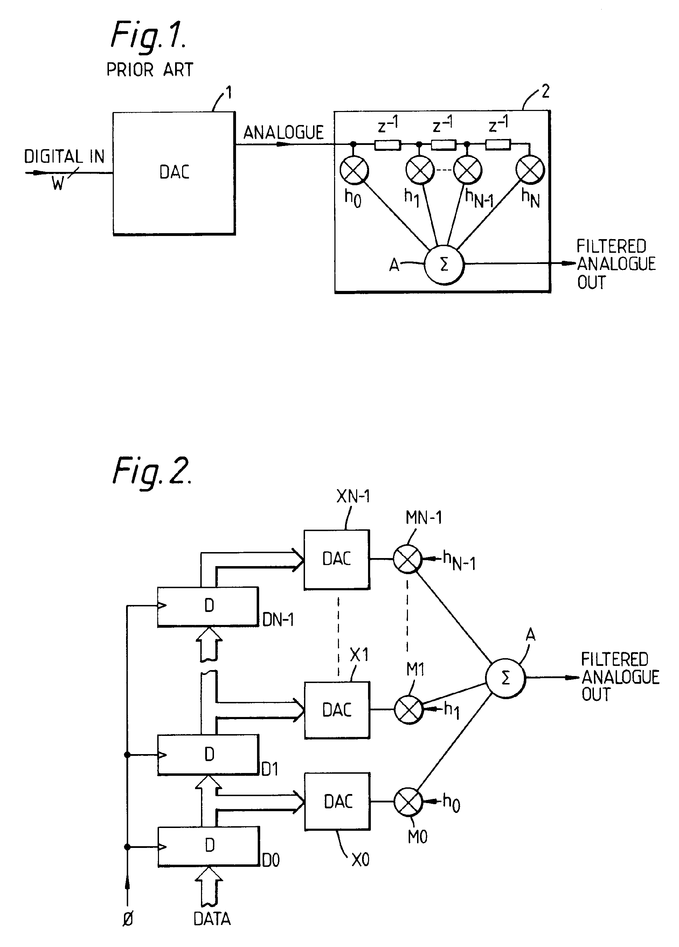

A typical, conventional filtering arrangement is shown in Figure 1, where successive sample values of a w-bit digital word [b₀b₁...bᵢ...b_{w-1}] are supplied to a digital-to-analogue converter (DAC) 1 followed by an analogue FIR (finite impulse response) filter 2, based on a conventional tapped delay line structure with delays z⁻¹, filter coefficient multipliers h₀...h_{N-1} and an adder A (or of course a parallel structure may be used). The coefficients are selected to give any desired filter response; in general this will be a baseband response from DC to half the sampling frequency Fₛ, followed by some rejection of unwanted frequencies above Fₛ/2.

The DAC may employ switched capacitor techniques (as described for example in Roubik Gregorian - "High Resolution Switched Capacitor D/A Converter" - Microelectronics Journal, Vol. 12, No. 2, 1981 Mackintosh Publ. Ltd); in the filter, the analogue delays may also be realised by switched-capacitor elements. The realisation of the analogue delays may however not be ideal.

Alternatively, the delays may be achieved digitally as described in US Patent No. 3,543,009 (Voelcker). An arrangement using this principle shown in Figure 2 and receives, as does that of Figure 1, successive w-bit digital samples of a signal to be converted. The digital words are fed to a chain of N w-bit wide D-type bistable flip-flops DO...DN-1 which are clocked at sampling rate Fₛ with clock pulses ∅, so that a digital word, delayed by a respective number of sample periods, is available at the output of each flip-flop. These outputs are converted into analogue form by digital-to-analogue converters XO...XW-1 which produce at their outputs successive analogue samples corresponding to the digital samples supplied to them. The analogue outputs are multiplied by respective filter coefficients hₒ...h_{N-1}; multipliers MO...MN-1 are shown though in the US patent resistors are used. The weighted analogue values are then summed in an adder A.
According to one aspect of the present invention there is provided an apparatus for producing a filtered analogue output signal from a digital signal in the form of a sequence of digital signal samples each having a plurality of bits comprising digital delay means for producing further sequences of digital signal samples, each being a replica of the first sequence delayed with respect thereto by a respective delay period, and means for forming an analogue signal representing the sum of the mutually delayed signal samples weighted in accordance with a desired filter response, in which the means for forming the analogue signal comprises
(a) a plurality of switched capacitor arrangements, each connected to receive a respective one of the said sequences of digital signal samples; each switched capacitor arrangement having at least one capacitor and switching means for supplying, in dependence on the states of bits of each received sample, charge thereto, such that the total charge received depends on the value represented by that sample; the totals each being weighted by a respective one of a set of coefficients corresponding to the desired filter response; and
(b) common summing means for receiving the charges from all the switched capacitor arrangements and forming an analogue output sequence representing the sum of those charges.

Each switch capacitor arrangement may have a plurality of capacitors with values weighted accorded to the significances of the respective sample bits; or each may have a single capacitor with switching means arranged to supply a predetermined quantity of change a respective different number of times. The desired filter response may be achieved by choosing the values of the capacitor(s) in one (or more) switched-capacitor arrangements to have value(s) different from the corresponding capacitor(s) in another.

Some embodiments of the present invention will now be described, by way of example, with reference to the accompanying drawings, in which:-
- Figure 3 is a circuit diagram of a known switched-capacitor unit;
- Figure 3a illustrates clock pulses used by the unit of Figure 3;
- Figure 4 is a block diagram of a further embodiment of filtered digital-to-analogue converter;
- Figure 5 is a modified version of part of Figure 3, for implementing negative filter coefficients;
- Figure 6 is a circuit diagram of a digital-to-analogue converter unit;
- Figure 7 illustrates the clock and switching pulses employed in the unit of Figure 6;
- Figure 8 is a block diagram of a filtered digital-to-analogue converter employing converter units of the type shown in Figure 6;
- Figure 9 is a modified version of part of Figure 6, for implementing negative filter coefficients;
- Figure 10 illustrates a practical implementation of the converter of Figure 8;
- Figure 11 is a block diagram of a pulse generator for driving the converter of Figure 10; and
- Figure 12 is a state diagram illustrating the operation of the generator of Figure 10.

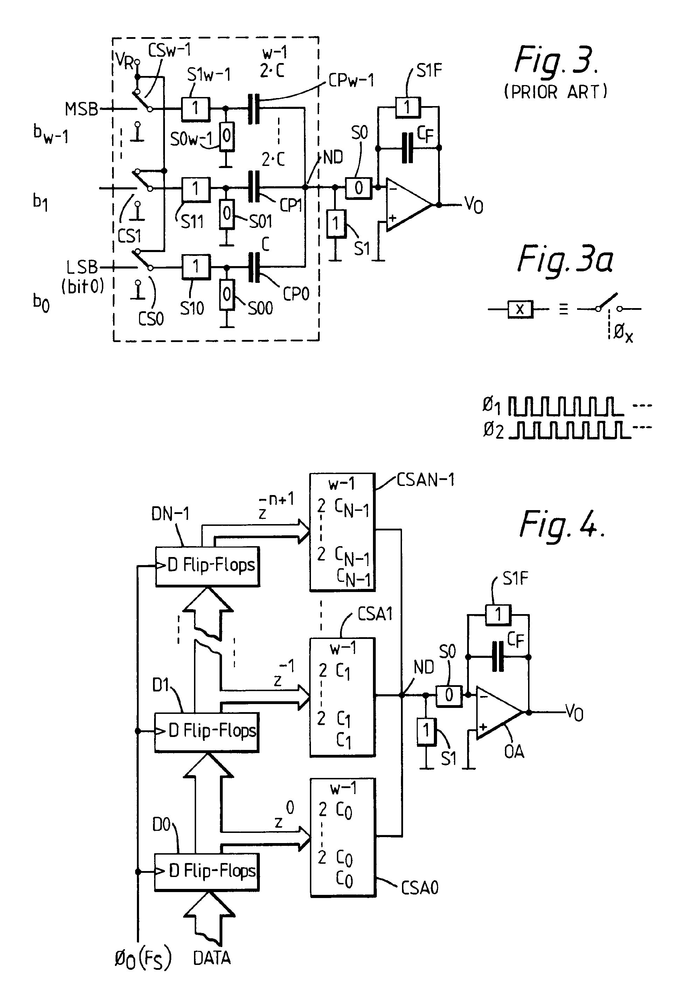

First, the operation of a known type of switched capacitor digital-to-analogue converter will be described with reference to Figure 3, where the input bits of a w-bit digital word are designated bₒ...b_{w-1} and each serves to switch, according to its binary value, an electronic switch CSO...CSw-1 (shown schematically) between zero volts (referred to below as "ground") and a reference voltage V_{R}. The converter contains a number of electronic switches controlled by the non-overlapping two-phase clock pulses ∅₀, ∅₁ at the sampling frequency Fₛ, which are shown in Figure 3a. In Figure 3 and elsewhere, the switches are shown as rectangles containing 0 or 1 indicating that the switch is closed during clock phase 0 or 1 respectively. Using the suffix i to indicate generically the components handling signals from one bit (bᵢ) of the input bits bₒ...b_{w-1}, the output of each switch CSi is connected via a switch Sli controlled by ∅₁ to one side of a capacitor CPi, which is also connected to ground via a switch SOi controlled by ∅ₒ. The other side of each capacitor CPi is connected to a common node ND, also connected to ground by a switch S1 controlled by ∅₁. The capacitors have binary weighted values - i.e. the capacitance of the capacitor CPi is 2ⁱ.C where C is the value of the smallest capacitor CPO. The node ND is also connected via a switch SO controlled by ∅ₒ to the input of a high gain inverting amplifier OA which has a negative feedback path consisting of a capacitor C_{F} in parallel with a switch S1F controlled by ∅₁.

During clock phase 1, the capacitor C_{F} is discharged via S1F. Also, each capacitor CPi is charged or discharged via switches S1i and S1 to the voltage (O or V_{R}) determined by the respective switch CSi. During clock phase φₒ, the total charge on the capacitors CPi 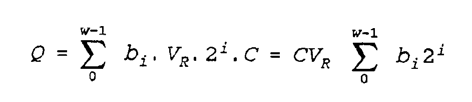
is transferred to the capacitor C_{F} so that the output of the converter is

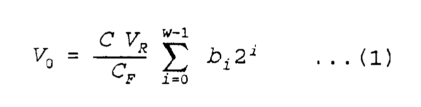

Figure 4 shows a filtered digital-to-analogue conversion apparatus according to a first embodiment of the invention where the node ND, switches S0, S1, S1F, capacitor C_{F} and amplifier OA are common to the N converters. The flip-flops DO...DN-1 are as in Figure 2, whilst the capacitor/switch array units CSAO...CSAN-1 correspond to the components enclosed in the broken line box in Figure 3. In this embodiment, the capacitor values in each array are chosen to weight the contribution of that array to the final output by a factor corresponding to the appropriate one of the desired filter coefficients hₒ...h_{N-1}.

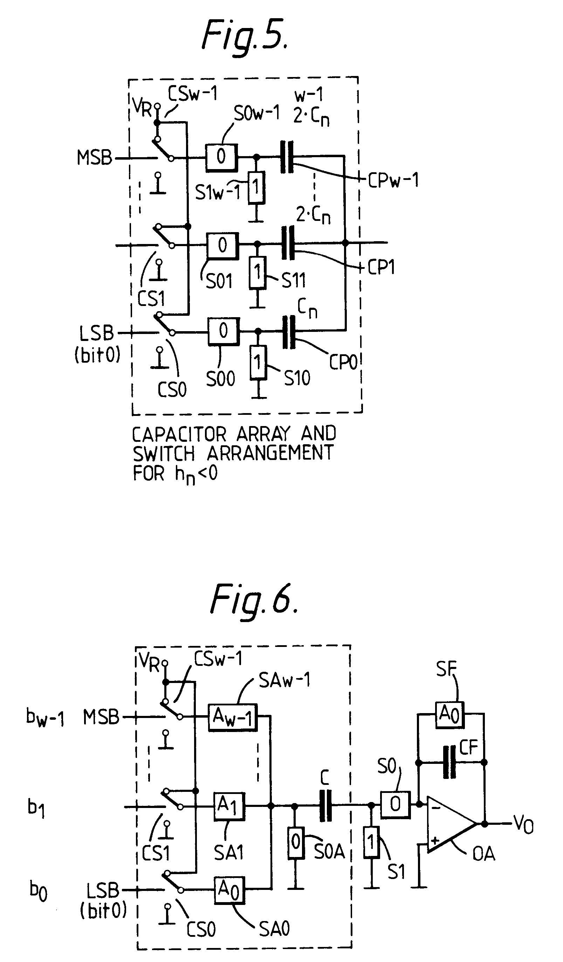

To accommodate negative coefficients, the array is modified by the transposition of the clock pulses illustrated in Figure 5 by transposition of switches S0i and Sli. The nth array (n=0,....,N-1) has capacitors with values 2ⁱ.Cₙ where Cₙ= |hₙ| .C* (C* being a constant), so that the contribution of this array to the total output voltage is 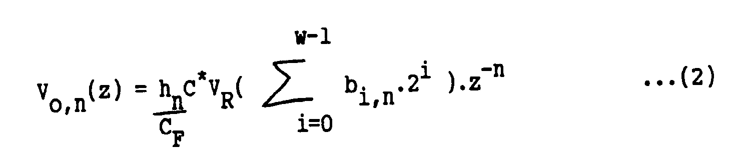
where z is the z-transform variable and b_{i,n} is the value of the ith bit of the digital word at the output of the nth D-type flip-flop. The contribution of all N words for an FIR filter of length N is

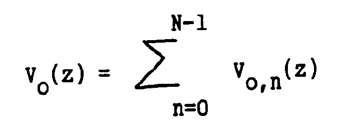

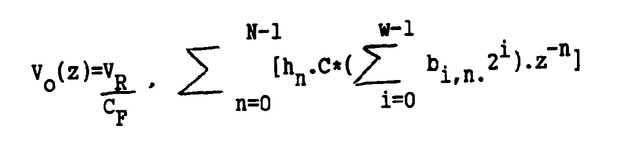

If we set C_{F}=2^{w}.C* then the output voltage is

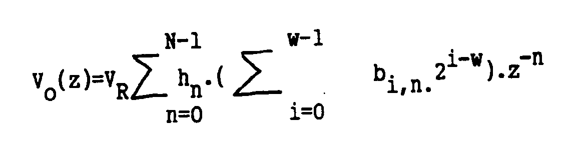

If the smallest capacitance value Cₙ is C, and the corresponding value of hₙ is hₙ ₘᵢₙ then the remaining capacitor values are given by${\text{C}}_{\text{n}} \text{=} \frac{{\text{|h}}_{\text{n}} \text{| .C}}{{\text{|h}}_{\text{n}} {\text{|}}_{\text{min}}}$
and${\text{C}}_{\text{F}} \text{=} \frac{{\text{2}}^{\text{w}} \text{.C}}{{\text{|h}}_{\text{n}} {\text{|}}_{\text{min}}}$

Since C_{F} is usually the largest capacitor in the circuit, we obtain a maximum capacitance spread of$\frac{{\text{C}}_{\text{F}}}{{\text{C}}_{\text{n min}}} \text{=} \frac{{\text{2}}^{\text{w}}}{{\text{|h}}_{\text{n min}} \text{|}}$
and a total capacitor area of

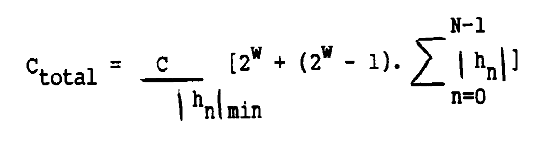

For an example of FIR filtering function with equal coefficients and unity DC gain (hₙ=1/N, n=0, ..., N-1) the above results lead to a capacitance spread of C_{spread} = N.2^{w} and a total capacitor area of Cₜₒₜₐₗ = N.(2^{w+1}-1).C.

The embodiment of Figure 4 requires (N.w)+1 capacitors and (2N.w) +3 switches, increasing with both the bit resolution w of the conversion and the length N of the desired filter impulse response. This means that, even for a medium bit resolution and short filter responses, the resulting silicon area required for an integrated circuit implementation can become rather large. An alternative converter is however now proposed, having reduced number of capacitors and switches.

Figure 6 shows a switched capacitor digital-to-analogue converter (without filtering). It can, as will be described in more detail below, be used to replace the converters X0..XN-1 of Figure 2, in the same manner as was the converter of Figure 3.

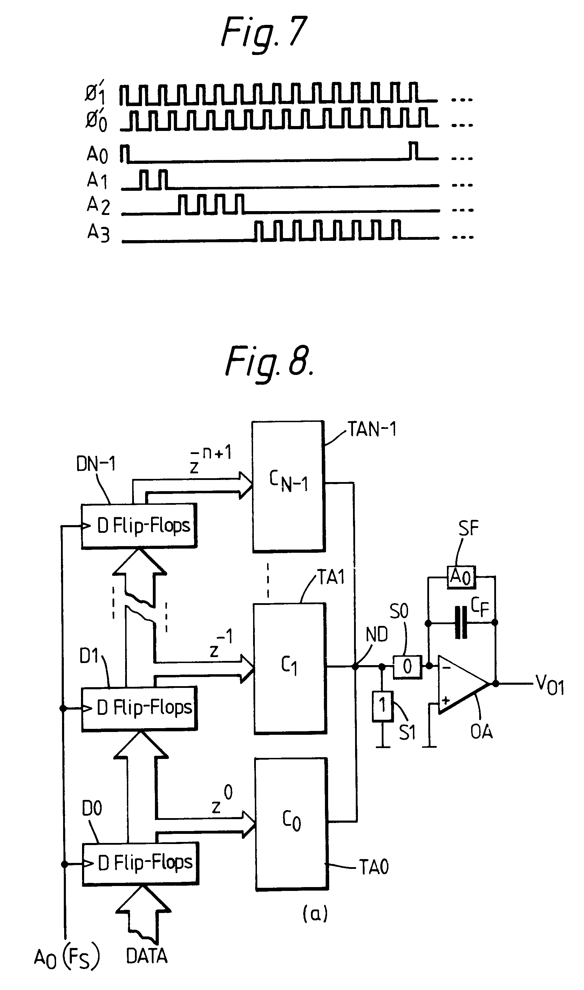

Input bits bᵢ and switches CSi perform the same functions as in Figure 3, as do switches S1, S0, SF, capacitor C_{F} and amplifier OA. However, the capacitors CPi and switches S0ᵢ are replaced by a single capacitor CP and switch S0A. The binary weighting of contribution of the w input bits is instead determined by the waveforms applied to the switches S1i (now designated SA0....SAi...SAw-1). Effectively the capacitor CP is multiplexed between the input bits. A set of switching waveforms φ′₁, φ′ₒ and Aₒ.. A_{w-1} for w=4 is illustrated in Figure 7.

Note that there are now 2^{w-1} clock pulses φ₁′ (or φₒ′) in one conversion period. The waveforms Aₒ...A_{w-1} contain 1, 2, 4 etc pulses synchronous with φ₁′ - ie in general the waveform Aᵢ contains 2ⁱ pulses. At the beginning of each conversion period, the feedback capacitor C_{F} is reset by the switch SF controlled by pulse Aₒ. Pulse Aₒ also closes switch SAO and the capacitor C assumes a voltage of 0 or V_{R} according to the state of bit bₒ. On the following clock pulse φₒ′ this charge is transferred to C_{F}. This process is repeated by pulse A₁ for bit b₁; however, this occurs twice, as A₁ contains two pulses, and so forth, the D/A conversion being performed sequentially from bit bₒ to bit b_{w-1}. The converted output is available during pulse ∅$\frac{\text{′}}{\text{o}}$ following the last pulse of A_{w-1}, prior to resetting of C_{F} by a further pulse Aₒ. Of course it is not actually necessary that the bits be processed in any particular sequence, or indeed that all the pulses for one particular bit be generated before those of another bit (though obviously the pulses must not coincide).

The equivalent bit voltage Vᵢ corresponding to each bit of the digital word is determined by the number of pulses of the corresponding switching waveform Aᵢ and can thus be expressed by${\text{V}}_{\text{i}} {\text{= V}}_{\text{R}} {\text{.b}}_{\text{i}} {\text{.2}}^{\text{i}}$
and therefore the converted output is

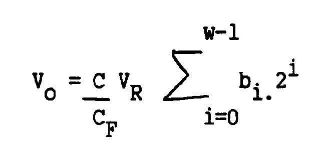

Assuming [V₀ max /V_{R}.(1-2^{-N})] = 1, we can easily see from the above expression that the capacitance spread of the converter in Figure 6 is equal to the capacitance spread of the conventional converter of Figure 3, ie (C_{F}/C)=2^{w}. However, the total capacitor area is now only (2^{w}+1).C, compared to 2^{w+1}.C in a conventional converter, and the total number of capacitors has also been reduced from (w+1) to only 2. An additional significant advantage of this new architecture is that, unlike conventional converters, the accuracy of the capacitance ratio C_{F}/C does not affect the required bit resolution, which depends solely on the number of time slots of each switching waveform. Thus, we can easily apply to the converter of Figure 6 a number of well known design techniques than can significantly reduce the capacitance spread in a switched-capacitor network (eg capacitive-T network), even though this also brings an inherent reduction of the resulting accuracy of the capacitance ratios. This makes it practical to implement high resolution converters using simple switched capacitor networks occupying a small area of silicon.

It is observed that, for a given maximum switching frequency, the conversion rate (and hence sampling rate of the digital words that can be accommodated) is reduced by a factor of (2^{w}-1) relative to Figure 3; however the reduction in capacitor area and required capacitance ratio accuracy make this embodiment particularly useful for high resolution conversions at lower frequency.

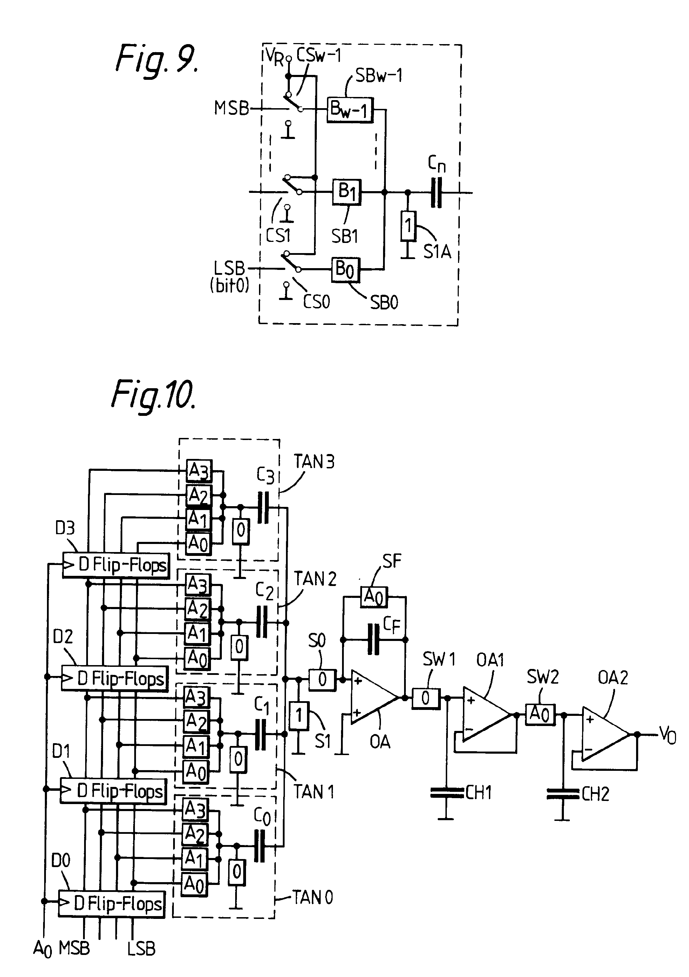

An implementation of a combined digital-to-analogue converter and FIR filter based on the binary-weighted time slot array architecture described above is illustrated in Figure 8. The flip-flops Dn are shown as for Figures 2 and 4. The converters Xn of Figure 2 are replaced by time slot arrays TAO to TAN-1, followed by common components S1, S0, OA, C_{F} and SF which are identical to those shown in Figure 6. Each time slot array TAi is either in the form indicated in the dotted rectangle in Figure 6 (for positive hₙ) or, for negative hₙ is structurally the same but is supplied with different pulses. Thus switches SAn supplied by pulses Aₙ and switch SOA supplied with pulses φ₀′ are replaced by switches SBn and S1A supplied with pulses Bₙ and φ₁′, as shown in Figure 9. Pulses Bₙ (n=0...n-1) take the same form as pulses Aₙ but are synchronous with φ₀′ instead of φ₁′.

As in the case of the architecture of Figure 2, we can easily see that the normalised output voltage conversion level corresponding to all N digital words is also expressed by 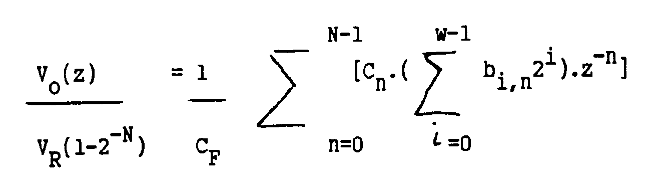
where${\text{C}}_{\text{n}} \text{=} \frac{{\text{|h}}_{\text{n}} {\text{| .C}}_{\text{F}}}{{\text{2}}^{\text{w}}}$
in order to preserve the gain constant of the FIR transfer function. After normalisation, we obtain${\text{C}}_{\text{nmin}} \text{= C}$${\text{C}}_{\text{n}} \text{=} \frac{{\text{|h}}_{\text{n}} \text{|}}{{\text{|h}}_{\text{n min}} \text{|}} \text{.C}$${\text{C}}_{\text{F}} \text{=} \frac{{\text{2}}^{\text{w}} \text{.C}}{{\text{|h}}_{\text{n min}} \text{|}}$
yielding a maximum capacitance spread of${\text{C}}_{\text{spread}} {\text{=}}^{\text{CF}} \text{/C =} \frac{{\text{2}}^{\text{w}}}{{\text{}}^{{\text{|h}}_{\text{n min}} \text{|}}}$
and 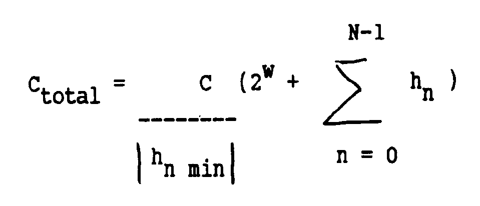
for the total capacitor area. For many practical situations where the FIR filter is designed such that 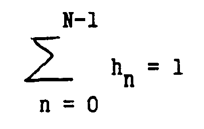
the above expression for Cₜₒₜₐₗ shows a reduction of about 50% over the total capacitor area obtained with the previous realisation. Two additional advantages of the architecture with binary-weighted time slot arrays are obtained firstly with respect to the total number of capacitors, which has been reduced from (N.w+1) to only (N+1), and, secondly, with respect to the required capacitance ratio accuracy of the impulse response coefficients of the FIR filter.

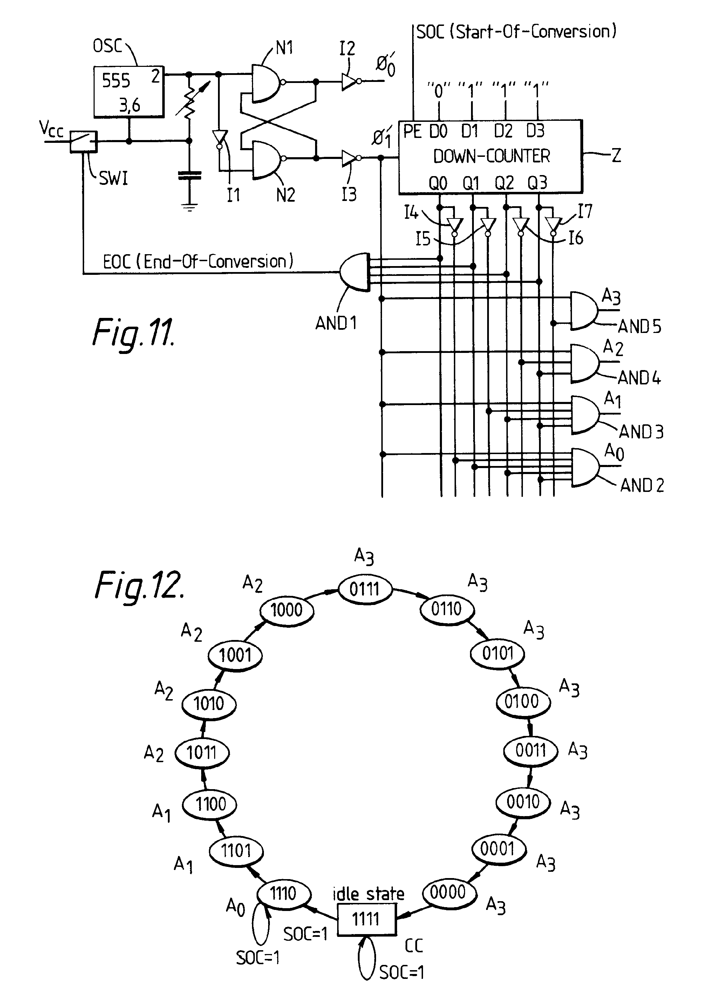

Figures 10 and 11 illustrate a simple practical implementation of the type of combined digital-to-analogue converter decribed above with reference to figure 8. It has 4-bit resolution and four equal FIR filter coefficients. The filter impulse response (in z-transform notation) is$\text{H (z) =} \frac{\text{1}}{\text{4}} \text{(1 + z⁻¹ + z⁻² + z⁻³).}$
There are four 4-bit wide D-type flip-flops D0, D1, D2, D3. Note that the fist of these is (as in the other figures) not strictly necessary but is included to ensure accurate timing. Also the switches CSi are omitted (on the basis that, for a 4-bit implementation, the voltages output directly from the flip-flops are themselves sufficiently consistent). There are three stages TAN0 ... TAN3, of the type shown in figure 6, with equal capacitor C0 ... C3 (= capacitance C) representing the four equal coefficients. Components S0, S1, SF, CF and OA are as shown in figure 6, whilst two simple sample and hold circuits SW1, CH1, OA1, SW2, CH2, OA2 are included to sample the output (A₀ being applied to switches SW1, SW1) when conversion is completed, to eliminate any output transients during conversion. C_{F} is equal to 64C for Vomax/V_{R} (1 - 2^{-N}) = 1.

The switching waveforms A₀, A₁, A₂, A₃ are generated by means of the generator shown in figure 11. A square-wave oscillator OSC drives a non-overlapping phasing generator consisting of an invertor I1, cross-coupled NAND gates N1, N2, and inverters I2, I3 to produce pulses ∅$\frac{\text{′}}{\text{o}}$, ∅$\frac{\text{′}}{\text{1}}$. A modulo 8 binary down-counter Z is clocked by ∅$\frac{\text{′}}{\text{1}}$. The '1111' state is designated as an idle-state in which the counter is locked by an and-gate AND1 which decodes this state to an end of conversion pulse EOC and inhibits clock pulses via a switch SWI in the oscillation circuit.

The generation of the required (2^{w}-1) = 15 pulses of the switching waveforms A₀ ... A₃ is indicated by an external pulse SOC (synchronous with the digital input data to be converted) which is applied to a paralled load input PE of the counter Z1 to load count '1110' into the counter.

The counter is then decremented by pulses ∅$\frac{\text{′}}{\text{1}}$ through its states to 000, during which period the counter states are decoded by inverters I4 ... I7 and and-gates AND2 ... AND4 to produce the pulses A₀ ... A₃ as illustrated in the sequence diagram in figure 12. The sixteenth pulse ∅$\frac{\text{′}}{\text{1}}$ returns the counter to the '1111' state where it remains locked until a further start pulse SOC is received.

Note that in this converter, pulses Bᵢ are not required (since the filter coefficients are all positive) but could of course be generated by a second counter and decoding logic similar to the arrangements for Aᵢ.

A discrete component version of this converter can be constructed using amplifiers type LF353, CMOS analogue switches type CD4016, and standard CMOS logic circuits, although in practice an integrated circuit implementation is to be preferred.

Typical capacitor values are C = 40pF and C_{F} = 2700pF (with ± 0.2% of the nominal values) may be used.

## Claims

1. An apparatus for producing a filtered analogue output signal from a digital signal in the form of a sequence of digital signal samples each having a plurality of bits comprising digital delay means (D0...DN-1) for producing further sequences of digital signal samples, each being a replica of the first sequence delayed with respect thereto by a respective delay period, and means for forming an analogue signal representing the sum of the mutually delayed signal samples weighted in accordance with a desired filter response, characterized in that the means for forming the analogue signal comprise a plurality of switched capacitor arrangements (CSAO...CSAN-1 or TAO...TAN-1), each connected to receive a respective one of the said sequences of digital signal samples; and in that each switched capacitor arrangement has at least one capacitor (CPO...CPw-1 or C) and switching means (CSO...CSw-1) for supplying, in dependence on the states of bits of each received sample, charge thereto, such that the total charge received by the capacitor(s) of each switched capacitor arrangement depends on the value represented by that sample; the total charge of each switched capacitor arrangement being weighted to weigh the contribution of each switched capacitor arrangement to the analogue output by a factor corresponding to a respective one of a set of coefficients corresponding to the desired filter response; and common summing means (S0, S1, SIF or SF, CF, OA) for receiving the charges from all the switched capacitor arrangements and forming an analogue output sequence representing the sum of those charges.

2. An apparatus according to Claim 1 characterised in that each switched capacitor arrangement has a plurality of capacitors (CPO...CPw-1) with values weighted according to the significances of respective bits of the samples.

3. An apparatus according to Claim 2, characterised in that the capacitors in at least one of the switched capacitor arrangements differ in value from the corresponding capacitors in another of the switched capacitor arrangements, such as to weight the charges by factors corresponding to the said coefficients.

4. An apparatus according to Claim 1 characterised in that each switched capacitor arrangement has a single capacitor (C) and switching means (CS1...CSw-1) for supplying, in dependence on the states of the bits of each received sample, charge to the single capacitor (C), the switching means being arranged to supply a predetermined quantity of charge to the capacitor a respective different number of times such that the charges supplied for respective bits of the sample are weighted according to the significances of those bits, thereby forming a total charge dependent on the value represented by the sample.

5. An apparatus according to Claim 4, characterised in that the capacitor in at least one of the switched capacitor arrangements differs in value from the corresponding capacitor in another of the switched capacitor arrangements, such as to weight the charges by factors corresponding to the said coefficients.

## Patentansprüche

1. Vorrichtung zum Erzeugen eines gefilterten analogen Ausgangssignals aus einem digitalen Signal in Form einer Folge von digitalen Signalproben mit jeweils einer Mehrzahl von Bits, die digitale Signalverzögerungseinrichtungen (D0 ... DN-1) zum Erzeugen von weiteren Folgen von digitalen Signalproben, deren jede eine gegen die erste Folge um einen jeweiligen Verzögerungszeitraum verzögerte Wiederholung derselben ist, und Einrichtungen zum Erzeugen eines analogen Signals, das die gemäß eines gewünschten Filterantwortverhaltens gewichtete Summe der gegeneinander verzögerten Signalproben darstellt, umfassen,
**dadurch** **gekennzeichnet**, **daß**
die Einrichtungen zum Erzeugen des analogen Signals umfassen:
eine Mehrzahl von Schalter-Kondensator-Anordnungen (CSAO ... CSAN-1 oder TAO ... TAN-1), von denen jede geschaltet ist, um jeweils eine der Folgen von digitalen Signalproben zu empfangen, wobei jede Schalter-Kondensator-Anordnung wenigstens einen Kondensator (CPO ... Cpw-1 oder C) und Schalteinrichtungen (CSO ... CSw-1) umfaßt, um in Abhängigkeit von den Bitzuständen jeder empfangenen Probe diesem Ladung zuzuführen, so daß die von dem Kondensator oder den Kondensatoren jeder Schalter-Kondensator-Anordnung empfangene Gesamtladung von dem durch diese Probe dargestellten Wert abhängt; wobei die Gesamtladung jeder Schalter-Kondensator-Anordnung gewichtet wird, um den Beitrag jeder Schalter-Kondensator-Anordnung zum analogen Ausgangssignal mit einem Faktor zu wichten, der jeweils einem Koeffizienten aus einem Satz von dem gewünschten Filterantwortverhalten entsprechenden Koeffizienten entspricht; und
Summationseinrichtungen (S0, S1, SIF oder SF, CF, OA) zum Empfangen der Ladungen von allen Schalter-Kondensator-Anordnungen und Erzeugen einer analogen Ausgangsfolge, die die Summe dieser Ladungen darstellt.

2. Vorrichtung nach Anspruch 1,
dadurch gekennzeichnet, daß
jede Schalter-Kondensator-Anordnung eine Mehrzahl von Kondensatoren (CPO ... Cpw-1) umfaßt, deren Werte gemäß der Signifikanz der entsprechenden Bits der Proben gewichtet sind.

3. Vorrichtung nach Anspruch 2,
dadurch gekennzeichnet, daß
die Kondensatoren in wenigstens einer der Schalter-Kondensator-Anordnungen sich im Wert von den entsprechenden Kondensatoren in einer anderen der Schalter-Kondensator-Anordnungen unterscheiden, um so die Ladungen mit den genannten Koeffizienten entsprechenden Faktoren zu gewichten.

4. Vorrichtung nach Anspruch 1,
dadurch gekennzeichnet, daß
jede Schalter-Kondensator-Anordnung einen einzigen Kondensator (C) und Schalteinrichtungen (CS1 ... CSw-1) umfaßt, um in Abhängigkeit von den Zuständen der Bits jeder empfangenen Probe Ladung dem einzigen Kondensator (C) zuzuführen, wobei die Schalteinrichtungen eingerichtet sind, um dem Kondensator eine vorgegebene Ladungsmenge eine jeweils unterschiedliche Zahl von Malen zuzuführen, so daß die für entsprechende Bits der Probe zugeführten Ladungen gemäß der Signifikanz dieser Bits gewichtet werden, wodurch eine von dem durch die Probe dargestellten Wert abhängige Gesamtladung gebildet wird.

5. Vorrichtung nach Anspruch 4,
dadurch gekennzeichnet, daß
der Kondensator in wenigstens einer der Schalter-Kondensator-Anordnungen sich im Wert von dem entsprechenden Kondensator in einer anderen der Schalter-Kondensator-Anordnungen unterscheidet, um so die Ladungen mit den genannten Koeffizienten entsprechenden Faktoren zu gewichten.

## Revendications

1. Appareil de production d'un signal de sortie analogique filtré, à partir d'un signal digital sous forme d'une séquence d'échantillons de signaux digitaux, chacun ayant une pluralité de bits comprenant des moyens (DO..DN-1) digitaux de retardement permettant la production de séquences supplémentaires d'échantillons de signaux, chacun étant une copie de la première séquence, retardée par rapport à cette dernière d'une période de retard correspondante, et des moyens permettant la formation d'un signal analogique représentant la somme des échantillons de signaux retardés mutuellement, pondérée selon une réponse de filtre voulue, caractérisé en ce que les moyens permettant la formation du signal analogique comprennent une pluralité d'arrangements (CSAO...CSAN-1 ou TAO...TAN-1) de condensateurs à commutation, chacun étant connecté de manière à recevoir l'une respective desdites séquences d'échantillons de signaux digitaux ; et en ce que chaque arrangement de condensateurs à commutation possède au moins un condensateur (CPO...CPw-1 ou C) et des moyens de commutation (CSO...CSw-1) permettant de leur fournir une charge en fonction des états des bits de chaque échantillon reçu, de sorte que la charge totale reçue par le(s) condensateur(s) de chaque arrangement dépend de la valeur représentée par cet échantillon, la charge totale de chaque arrangement de condensateurs étant pondérée de manière à pondérer la contribution de chaque arrangement de condensateurs à la sortie analogique, par un facteur correspondant respectivement à l'un choisi parmi un jeu de coefficients correspondant à la réponse de filtre désirée ; et des moyens d'addition (SO, S1, SIF ou SF, CF, OA) communs permettant la réception des charges à partir de tous les arrangements de condensateurs, et la formation d'une séquence de sortie analogique représentant la somme de ces charges.

2. Appareil selon la revendication 1, caractérisé en ce que chaque arrangement de condensateurs à commutation possède une pluralité de condensateurs (CPO...CPw-1) présentant des valeurs pondérées selon les valeurs significatives des bits respectifs des échantillons.

3. Appareil selon la revendication 2, caractérisé en ce que les condensateurs d'au moins l'un des arrangements diffèrent, dans leurs valeurs, des condensateurs correspondants d'un autre arrangement, de manière à pondérer les charges par des facteurs correspondant auxdits coefficients.

4. Appareil selon la revendication 1, caractérisé que ce que chaque arrangement de condensateurs à commutation possède un seul condensateur (C) et des moyens de commutations (CS1...CSw-1) permettant de fournir une charge au condensateur (C) en fonction des états des bits de chaque échantillon reçu, les moyens de commutation étant réalisés de manière à fournir une quantité prédéterminée de charge au condensateur, un nombre de fois différent de sorte que les charges fournies pour des bits respectifs de l'échantillon sont pondérées selon les valeurs significatives de ces bits, de sorte que la charge totale est dépendante de la valeur représentée par l'échantillon.

5. Appareil selon la revendication 4, caractérisé en ce que le condensateur de l'un au moins des arrangements diffère, dans sa valeur, du condensateur correspondant d'un autre arrangement, de manière à pondérer les charges par des facteurs correspondant auxdits coefficients.
